(19) Europäisches Patentamt / European Patent Office / Office européen des brevets

(11) **EP 1 895 662 A1**

(12) **EUROPEAN PATENT APPLICATION**
published in accordance with Art. 153(4) EPC

(43) Date of publication:
**05.03.2008 Bulletin 2008/10**

(51) Int Cl.:
**H03L 7/00** (2006.01)

(21) Application number: **06756544.0**

(22) Date of filing: **24.05.2006**

(86) International application number:
**PCT/JP2006/310338**

(87) International publication number:
**WO 2006/137238 (28.12.2006 Gazette 2006/52)**

(84) Designated Contracting States:
**DE FR GB**

(30) Priority: **21.06.2005 JP 2005180429**

(71) Applicant: **Pioneer Corporation**
**Tokyo 153-8654 (JP)**

(72) Inventor: **KUBUKI, Toshiaki,**
**c/o Kawagoe Koujou**
**Kawagoe-shi,**
**Saitama 350-8555 (JP)**

(74) Representative: **Sajda, Wolf E. et al**
**MEISSNER, BOLTE & PARTNER**
**Postfach 86 06 24**
**D-8000 München 86 (DE)**

(54) **PHASE CORRECTING CIRCUIT**

(57) It is an object of the present invention to provide a phase correction circuit for correcting a phase difference of desired signal component contained in an input signal and then extracting desired signal component.

Desired signal components (S1, S2) contained in an input signal (Sin) are extracted by virtue of filters (BPF1, BP2) having characteristics of several stages, and the phases of the signal components (S1, S2) are then shifted by π/2 or -π/2 in a phase-shifting unit (3), thereby generating phase-shifted signals (P1, P2). A phase difference detection unit (4) detects phase differences (phase deviations) α of the signal components (S1, S2) occurred when passing through the filters (BPF1, BP2), in accordance with the signal components (S1, S2) and the phase-shifted signals (P1, P2), thereby generating as phase difference detection signals (E1, E2) the signals of the orthogonal functions taking the phase differences α as parameters. A phase difference correction circuit (5) shifts the phases of the signal components (S1, S2) and the phase-shifted signals (P1, P2) in accordance with the phase difference detection signals (E1, E2), thereby generating the desired signal components having the phase differences (phase deviations) α corrected, and thus outputting the same as output signal (Sout).

*FIG.1*

EP 1 895 662 A1

**Description**

Technical Field

The present invention relates to a phase correction circuit which carries out an extraction or the like of desired signal components without causing phase deviations during a signal processing.

Background Technique

As a technique for extracting desired signal components during a signal processing, there has been known, for example, a pilot signal extraction circuit which extracts, from an FM detection signal detected by a detector of an FM receiver, a pilot signal for use in a signal processing such as demodulation or the like.

Conventionally, in the above-mentioned pilot signal extraction circuit, it is usual to frequency separate and thus extract a pilot signal having a frequency of 19 kHz from an FM detection signal by means of a high-Q (Q factor) band pass filter, and to use PLL circuit to correct a phase deviation of the pilot signal occurred when passing through the band pass filter, thereby extracting a pilot signal not involving any phase deviation. Further, a pilot-signal involving a phase deviation occurred when passing through the above high-Q band pass filter is sampled in synchronism with a sampling clock which is integer times of 19 kHz, followed by applying a digital signal processing to the sampled digital signal, thereby generating a pilot signal not containing any phase deviation.

Disclosure of the Invention

Problems to be Solved by the Invention

However, in the above-mentioned conventional pilot signal extraction circuit which extracts a pilot-signal by virtue of the band pass filter and PLL circuit, since there is a delay during a process in which the PLL circuit applies a phase-lock to the pilot signal, it is impossible to effect a maximum separation. Besides, if an audio signal demodulated by a pilot signal not synchronized is reproduced by a speaker, there will be a problem such as a sound tremble.

Moreover, in the above-mentioned conventional pilot signal extraction circuit which, by virtue of digital signal processing, corrects a phase deviation of a pilot signal extracted by the band pass filter, since the operation of the extraction circuit depends on a frequency precision of a pilot signal contained in an FM wave as well as depends on the precision of the sampling clock, the problem of phase deviation will become even more severe.

The present invention has been accomplished in view of the above conventional problem and it is an object of the invention to provide a phase correction circuit which can perform a high speed processing, correct a phase deviation with a high precision, and thus extract desired signal components.

Moreover, it is another object of the present invention to provide a phase correction circuit which cannot only extract a pilot signal from an FM detection signal, but also has a versatility capable of use in various technical fields.

Means for Solving the Problems

The invention recited in claim 1 provides a phase correction circuit for correcting a phase difference of a desired signal component contained in an input signal and then extracting the desired signal component, the phase correction circuit comprising: filter means having characteristics of several stages for extracting the desired signal component contained in the input signal; phase shifting means for shifting a predetermined amount of phase of a signal component extracted by each filter means and generating a phase-shifted signal; phase difference detection means for performing a computation using an addition theorem of trigonometric functions to process the signal component extracted by each filter means and the phase-shifted signal generated by the phase shifting means, thereby detecting a phase difference of the signal component; and phase difference correction means for shifting the phase of the signal component extracted by each filter means and the phase of the phase-shifted signal in accordance with the phase difference detected by the phase difference detection means, thereby generating a signal component having the phase difference corrected.

The invention recited in claim 2 provides a phase correction circuit for correcting a phase difference of a desired signal component contained in an input signal and then extracting the desired signal component, the phase correction circuit comprising: first filter means having characteristics of several stages for extracting a desired signal component contained in the input signal; phase shifting means for shifting a predetermined amount of phase of the input signal; second filter means having characteristics consistent with the first filter means for extracting, from an output signal of the phase shifting means, a phase-shifted signal formed by shifting the predetermined amount of phase of the desired signal component contained in the input signal; phase difference detection means for performing a computation using an addition theorem of trigonometric functions to process the signal component extracted by the first filter means and the phase-shifted signal extracted by the second filter means, thereby detecting a phase difference of the signal component; and phase difference correction means for shifting the phase of the signal component extracted by the first filter means and the phase-shifted signal extracted by the second filter means in accordance with the phase difference detected by the phase difference detection means, thereby generating a signal component having the phase difference corrected.

Brief Description of the Drawings

Fig. 1    is a block diagram showing the structure of a phase correction circuit formed according to a preferred embodiment.
Fig. 2    is a block diagram showing the structure of a phase correction circuit formed according to one embodiment.
Fig. 3    is a block diagram showing the structure of a phase correction circuit formed according to another embodiment.
Fig. 4    is a block diagram showing the structure of a phase correction circuit formed according to a further embodiment.

Best Mode of Carrying Out the Invention

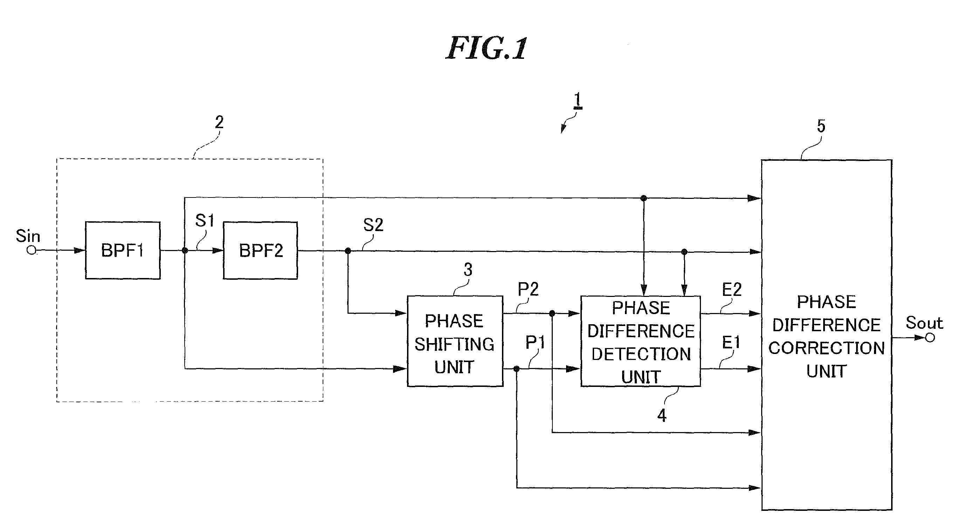

A preferred embodiment of the present invention will be described with reference to Fig. 1 which is a block diagram showing the structure of a phase correction circuit formed according to the present embodiment.
As shown in Fig. 1, the phase correction circuit 1 comprises a signal extraction section 2, a phase shifting unit 3, a phase difference detection unit 4, and a phase difference correction unit 5. The signal extraction section 2 includes a plurality of band pass filters BPF1 and BPF2 which pass therethrough only signal components of desired frequency contained in an input signal Sin.
Both of the above-mentioned band pass filters BPF1 and BPF2 which are connected in series and each of which takes the above frequency f as a center frequency, are formed of band pass filters each having a pass band for passing a desired signal component contained in an input signal Sin and having various desired characteristics. In more detail, the front band pass filter BPF1 passes a desired signal component S 1 having the frequency f and contained in the input signal Sin, while the rear band pass filter BPF2 further passes the signal component S 1 so that it is output as a signal component S2.
Therefore, as shown in the following equation (1-a), if sine wave Asin ($\omega$t) represents a desired signal component contained in an input signal Sin, f(t) represents other signal components, and $\alpha$ represents various phase differences (phase deviations) of signal components having passed through the band pass filters BPF 1 and BPF2, a signal component S 1 output from the band pass filter BPF 1 will deviate a phase $\alpha$, as shown in the following equation (1-b), while a signal component S2 output from the band pass filter BPF2 will deviate a phase 2$\alpha$, as shown in the following equation (1-c).
### Equation 1

$$Sin = f(t) + Asin(\omega t) \text{ (where } \omega = 2\pi f, A \text{ is an amplitude)} \ldots (1\text{-}a)$$

$$S1 = Asin(\omega t - \alpha) \ldots (1\text{-}b)$$

$$S2 = Asin(\omega t - 2\alpha) \ldots (1\text{-}c)$$

The phase shifting unit 3 shifts the phases of the signal components S 1 and S2 output from the band pass filters BPF 1 and BPF2 by $\pi/2$, thereby outputting signals P and P2 having their phases shifted (hereinafter referred to as "phase-shifted signals").
Therefore, the signal components S1 and S2 will become phase-shifted signals P1 and P2 represented by the following equations (2-a), (2-b) and thus output.
### Equation 2

$$P1 = Asin(\omega t - \alpha + \pi/2) = Acos(\omega t - \alpha) \quad --- (2\text{-}a)$$

$$P2 = Asin(\omega t - 2\alpha + \pi/2) = Acos(\omega t - 2\alpha) \quad --- (2\text{-}b)$$

The phase difference detection unit 4 receives the signal components S 1 and S2 from the band pass filters BPF1 and BPF2 as well as the phase-shifted signals P1 and P2 from the phase-shifting unit 3, performs a computation using an addition theorem of trigonometric function, thereby detecting a phase difference between the signal components S1 and S2, a phase difference between the signal component S2 and the phase-shifted signal P1, a phase difference between the signal component S1 and the phase-shifted signal P2, as well as a phase difference between the phase-shifted signals P1 and P2.

Then, as shown in the following equations (3-a) and (3-b), the phase difference detection unit 4 outputs signals E1 and E2 of orthogonal function whose parameters are detected phase differences $\alpha$, i.e., phase difference detection signal E1 represented by sine wave $B\sin(\alpha)$ and phase difference detection signal E2 represented by cosine wave $B\cos(\alpha)$.

$$\underline{\text{Equation 3}}$$

$$E1 = B\sin(\alpha) \text{ (where B is an amplitude)} \dots (3\text{-}a)$$

$$E2 = B\cos(\alpha) \dots (3\text{-}b)$$

The phase difference correction unit 5 shifts the phases of the phase-shifted signal P1 and the signal component S1 in accordance with the phase difference detection signals E1 and E2, thereby generating and producing an output signal Sout which is a signal component having its phase difference $\alpha$ corrected.

Namely, the phase difference correction unit 5 performs a phase-shifting process expressed by the following matrix equation (4), and produces as an output signal Sout a signal component $K\sin(\omega t)$ having the same phase as the signal component $A\sin(\omega t)$ contained in the input signal Sin. Alternatively, the phase difference correction unit 5 produces as an output signal Sout a signal component $K\cos(\omega t)$ having its phase shifted by $\pi/2$ with respect to the signal component $A\sin(\omega t)$ contained in the input signal Sin.

Then, in response to an operating state of the phase correction circuit 1 of the present embodiment, either one or both of the signal component $K\sin(\omega t)$ and the signal component $K\cos(\omega t)$ are output as an output signal Sout. Here, the coefficient K represents an amplitude.

$$\underline{\text{Equation 4}}$$

$$\begin{bmatrix} E2 & -E1 \\ E1 & E2 \end{bmatrix} \begin{bmatrix} P1 \\ S1 \end{bmatrix} = \begin{bmatrix} B\cos(\alpha) & -B\sin(\alpha) \\ B\sin(\alpha) & B\cos(\alpha) \end{bmatrix} \begin{bmatrix} P1 \\ S1 \end{bmatrix} = \begin{bmatrix} K\cos(\omega t) \\ K\sin(\omega t) \end{bmatrix} \quad \text{---}(4)$$

As explained in more detail, the phase difference correction unit 5 performs a processing (which is a computation using an addition theorem of trigonometric function) represented by the following equations (5-a) and (5-b) obtained by developing the above matrix equation (4), thereby generating the signal components $K\cos(\omega t)$ and $K\sin(\omega t)$ having corrected the phase differences (phase deviations) of the band pass filters BPF1 and BPF2, thus outputting the same as the output signal Sout.

Equation 5

$$Bcos(\alpha) \cdot Acos(\omega t - \alpha) - Bsin(\alpha) \cdot Asin(\omega t - \alpha)$$
$$= Kcos(\omega t) = Sout \qquad\qquad --- (5-a)$$

$$Bcos(\alpha) \cdot Acos(\omega t - \alpha) + Bcos(\alpha) \cdot Asin(\omega t - \alpha)$$
$$= Ksin(\omega t) = Sout \qquad\qquad --- (5-b)$$

As explained above, the phase correction circuit 1 of the present embodiment operates in accordance with signal components S1 and S2 extracted from the input signal Sin by the band pass filters BPF1 and BPF2 having all the desired characteristics, as well as the phase-shifted signals P1 and P2 formed by shifting the phases of these signal components S1 and S2 by π/2.
The phase difference detection unit 4 detects the phase differences (phase deviations) α of the signal components S1 and S2, while the phase difference correction unit 5 operates in accordance with the phase difference detection signals E1 and E2 which are orthogonal functions taking the detected phase differences as parameters, so as to shift the phases of the phase-shifted signal P1 and the signal component S1, thereby generating a signal component having its phase deviation corrected, and thus outputting the same as an output signal Sout.

In this way, according to the phase correction circuit 1 of the present embodiment, since no feedback loop exists in a process which lasts until it extracts a desired signal component from an input signal Sin and outputs an output signal Sout, it is possible to extremely quickly generate an output signal Sout having its phase deviation corrected.

For this reason, as a concrete example, if an FM detection signal detected by the receiver is input as an input signal Sin and the center frequency f of the band pass filters BPF 1 and BPF2 is set at 19 kHz, it is possible to instantly extract a pilot signal having its phase deviation corrected if it appears to be necessary to extract a pilot signal contained in the FM detection signal. Further, when demodulation or the like is applied to the FM detection signal in synchronism with the extracted pilot signal so as to generate an audio signal which is then supplied to a speaker, it is possible to reproduce a sound which is free from any tremble.

Moreover, the phase correction circuit 1 of the present embodiment can also be formed of an analog circuit capable of performing an analog signal processing, or a digital circuit which performs a digital signal processing. For example, the band pass filters BPF1 and BPF2 can be formed of digital filters which perform digital filtering in synchronism with a sampling clock having a higher frequency than the Nyquist frequency.
The phase shifting unit 3, the phase difference detection unit 4, and phase difference correction unit 5 can be similarly formed of digital circuits which perform digital signal processing in synchronism with the sampling clock. In this way, the digital signal A/D converted using the sampling frequency of the above sampling clock is processed as an input signal Sin, rendering it possible to generate a desired signal component having its phase deviation corrected, as an output signal Sout consisting of digital signal.

Then, when the phase correction circuit 1 is formed of digital circuit, it is possible to correct a phase deviation with an acceptable precision, thereby generating and thus outputting an output signal Sout consisting of digital signal, without depending upon a frequency precision of a desired signal component and the precision of the sampling clock.

Moreover, although the above description shows that a phase shifting amount with respect to the signal components S 1 and S2 of the phase-shifting unit 3 is π/2, it is also possible to perform a phase shifting by -π/2.

Further, according to the above description, as shown in equations (4), (5-a), and (5-b), the phase difference correction unit 5 shifts the phases of the phase-shifted signal P1 and the signal component S1 in accordance with the phase difference detection signals E1 and E2, thereby generating an output signal Sout having phase deviation corrected. However, as shown in the following equation (6), it is also possible to shift the phases of the phase-shifted signal P2 and the signal component S2 each having a phase deviation equal to a phase difference 2α, in accordance with the phase difference detection signals E12 and E22 which are the orthogonal functions taking phase differences 2α as parameters, thereby generating an output signal Sout having phase deviation corrected.

Equation 6

$$
\begin{bmatrix} E22 & -E12 \\ E12 & E22 \end{bmatrix} \begin{bmatrix} P2 \\ S2 \end{bmatrix} = \begin{bmatrix} Bcos(2\alpha) & -Bsin(2\alpha) \\ Bsin(2\alpha) & Bcos(2\alpha) \end{bmatrix} \begin{bmatrix} P2 \\ S2 \end{bmatrix} = \begin{bmatrix} Kcos(\omega t) \\ Ksin(\omega t) \end{bmatrix} \quad ---(6)
$$

Moreover, although the phase correction circuit 1 shown in Fig. 1 contains two band pass filters BPF1 and BPF2, the phase correction circuit of the present embodiment has an extendibility. In particular, when n (n is 2 or more) band pass filters BPF1 - BPFn having the same characteristic are connected in series, it is possible to correct a phase deviation occurred in any one band pass filter among the band pass filters BPF1 - BPFn, thereby generating an output signal Sout not involving any phase deviation.

Namely, the phase difference detection unit 4 detects a phase difference detection signal E1m represented by Bcos(m$\alpha$) and another phase difference detection signal E2m represented by Bsin(m$\alpha$), which are orthogonal functions taking as parameters phase differences m$\alpha$ equivalent to an arbitrary number of stages m (m $\le$ n) output from the band pass filters BPF1 - BPFn.

The phase difference correction unit 5 can, as shown in the following equation (7), shift the phases of the signal component Sm and the phase-shifted signal Pm having a phase deviation equal to a phase difference m$\alpha$, in accordance with the phase difference detection signals E1m and E2m, thereby generating and thus outputting an output signal Sout having the phase difference m$\alpha$ corrected.

Equation 7

$$
\begin{bmatrix} E2m & -E1m \\ E1m & E2m \end{bmatrix} \begin{bmatrix} Pm \\ Sm \end{bmatrix} = \begin{bmatrix} Bcos(m\alpha) & -Bsin(m\alpha) \\ Bsin(m\alpha) & Bcos(m\alpha) \end{bmatrix} \begin{bmatrix} Pm \\ Sm \end{bmatrix} = \begin{bmatrix} Kcos(\omega t) \\ Ksin(\omega t) \end{bmatrix} \quad ---(7)
$$

Further, although the phase correction circuit 1 described above can extract the desired signal components S1 and S2 by virtue of the band pass filters BPF1 and BPF2, it is also possible to replace the band pass filters BPF1 and BPF2 with other types of filters such as high pass filter and low pass filter, thereby correcting a phase deviation when extracting a desired signal component.

Moreover, the phase correction circuit 1 of the present embodiment should not be limited to the use in correcting a phase deviation when extracting a desired pilot signal from an FM detection signal, but has a versatility which makes it possible for the phase correction circuit to be used in various fields.

Besides, it is also possible to prepare a computer program which can provide the same functions as the above-described phase correction circuit 1 by virtue of electronic computation means such as a microprocessor (MPU) and a digital signal processor (DSP), thereby allowing the microprocessor (MPU) and the digital signal processor (DSP) or the like to operate in accordance with the computer program, thus effecting a desired phase correction.

Embodiment 1

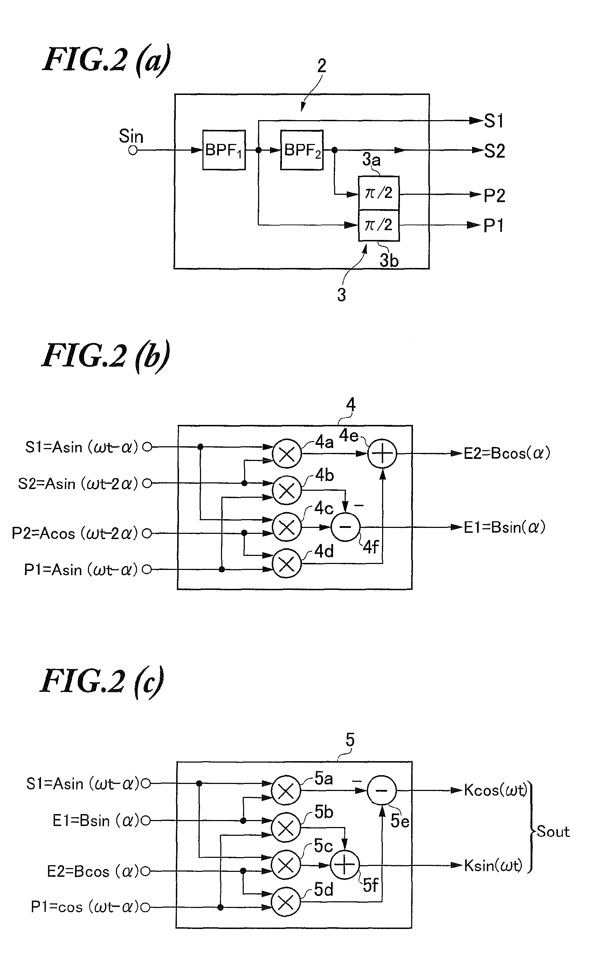

Next, description will be given to explain a more concrete embodiment of the phase correction circuit of Fig. 1, with reference to Fig. 2. Fig. 2(a) is a block diagram showing the structures of the signal extraction unit 2 and the phase-shifting unit 3, Fig. 2(b) is a block diagram showing the structure of the phase difference detection unit 4, Fig. 2(c) is a block diagram showing the structure of the phase difference correction unit 5.

As shown in Fig. 2(a), the signal extraction unit 2 is formed by including the band pass filters BPF 1 and BPF2 covering all desired characteristics, each having a predetermined pass band with a predetermined frequency f as its center frequency.

By allowing the desired signal components contained in an input signal Sin to pass through pass bands, the band pass filters will extract and then output the desired signal components as signal components S1 and S2 having phase differences α, 2α.

The phase-shifting unit 3 includes: a phase-shifter 3a which shifts the phase of the signal component S2 by π/2 and then outputs a phase-shifted signal P2; and a phase-shifter 3b which shifts the phase of the signal component S 1 by π/2 and then outputs a phase-shifted signal P1. By carrying out the computation using the above constitution, the signal components S1 and S2 shown in the equations (1-b), (1-c) are output from the band pass filters BPF1 and BPF2, while the phase-shifted signals P1, P2 shown in the equations (2-a), (2-b) are output from the phase shifters 3a and 3b.

Next, as shown in Fig. 2(b), the phase difference detection unit 4 is formed by including multipliers 4a, 4b, 4c, 4d, an adder 4e and a subtractor 4f. In more detail, the multiplier 4a multiplies together signal components S 1 and S2, the multiplier 4b multiplies together a signal component S2 and a phase-shifted signal P1, the multiplier 4c multiplies together a signal component S 1 and a phase-shifted signal P2, the multiplier 4d multiplies together the phase-shifted signals P1 and P2, the adder 4e adds together the multiplication results of the multipliers 4a and 4d, the subtractor 4f subtracts the computation result of the multiplier 4b from the computation result of the multiplier 4c.

Upon performing the computations using the above constitution, a phase difference detection signal E1 expressed by the sine wave Bsin(α) which is an orthogonal function taking a phase difference α as its parameter will be output from the subtractor 4f, as shown in the following equation (8-a), while the adder 4e outputs a phase difference detection signal E2 represented by the cosine wave Bsin(α) which is an orthogonal function taking a phase difference α as its parameter, as shown in the following equation (8-b).

Equation 8

$$E1 = S1 \cdot P2 - S2 \cdot P1$$
$$= A\sin(\omega t - \alpha) \cdot A\cos(\omega t - 2\alpha) - A\sin(\omega t - 2\alpha) \cdot A\cos(\omega t - \alpha)$$
$$= B\sin(\alpha) \qquad\qquad\qquad \text{---(8-a)}$$

$$E2 = S1 \cdot S2 - P1 \cdot P2$$
$$= A\sin(\omega t - \alpha) \cdot A\sin(\omega t - 2\alpha) + A\cos(\omega t - 2\alpha) \cdot A\cos(\omega t - \alpha)$$
$$= B\cos(\alpha) \qquad\qquad\qquad \text{---(8-b)}$$

Next, as shown in Fig. 2(c), the phase difference correction unit 5 is formed by including multipliers 5a, 5b, 5c, 5d, a subtractor 5e, and an adder 5f. In more detail, the multiplier 5a multiplies together a signal component S1 and a phase difference detection signal E1, the multiplier 5b multiplies together a phase difference detection signal E1 and a phase-shifted signal P1, the multiplier 5c multiplies together a signal component S1 and a phase difference detection signal E2, the multiplier 5d multiplies together a phase difference detection signal E2 and a phase-shifted signal P1.

Further, the subtractor 5e subtracts the computation result of the multiplier 5a from the computation result of the multiplier 5d, while the adder 5f adds together the multiplication results of the multipliers 5b and 5c. Upon performing the computations using the above constitution, a phase shifting processing shown in the above equation (4) will be carried out, and the subtractor 5e will produce an output signal Sout represented by the cosine wave Kcos(ωt) shown in the above equation (5-a) and having phase deviation corrected, while the adder 5f produces an output signal Sout represented by the sine wave Ksin (ωt) shown in the above equation (5-b) and having phase deviation corrected.

In this way, according to the phase correction circuit of the present embodiment, since the phase difference detection unit 4 and the phase difference correction unit 5 are formed by including a number of multipliers, an adder, and a subtractor, it is possible for the phase correction circuit to reduce the number of its elements, so that the circuit becomes simple in its structure and compact in size. Further, it is also possible to provide a phase correction circuit capable of a high speed processing.

Moreover, since no feedback loop exists in a process which lasts until it extracts a desired signal component from an input signal Sin and outputs an output signal Sout having phase deviation corrected, it is possible to extremely quickly generate an output signal Sout having phase deviation corrected.

Further, the phase correction circuit of the present embodiment can be formed either of an analog circuit which performs an analog signal processing, or a digital circuit which performs a digital signal processing.

When the phase correction circuit is formed of a digital circuit, it is possible to highly accurately correct a phase deviation, generate and thus output an output signal Sout consisting of digital signal, without depending upon a frequency precision of a desired signal and the precision of a sampling clock.

Embodiment 2

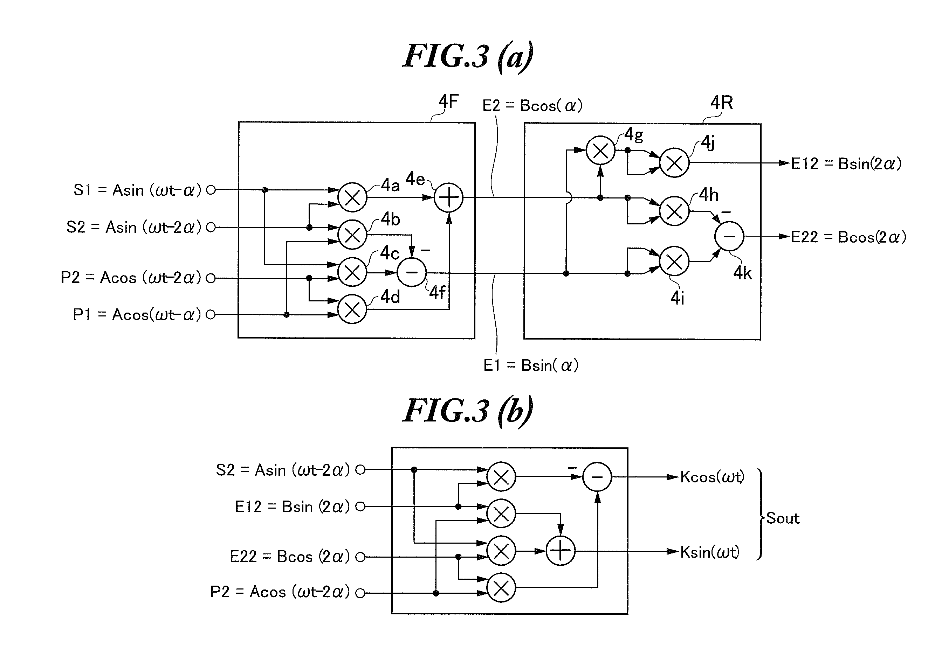

Next, description will be given to explain other embodiment equivalent to a modification of the phase correction circuit shown in Fig. 2, with reference to Fig. 3.

Fig. 3(a) is a block diagram showing the structure of the phase difference detection unit 4 and Fig. 3(b) is a block diagram showing the structure of the phase difference correction unit 5.

The phase correction circuit of the present embodiment includes a signal extraction unit 2 and a phase-shifting unit 3. Signal components S1, S2 and phase-shifted signals P1, P2 output from the signal extraction unit 2 and the phase-shifting unit 3 are supplied to the phase difference detection unit 4 shown in Fig. 3(a).

Further, the phase difference detection signals E12, E22 and the signal component S2 generated by the phase difference detection unit 4, as well as the phase-shifted signal P2 are supplied to the phase difference correction unit 5, thereby allowing the phase difference correction unit 5 to output an output signal Sout having phase deviation corrected.

Namely, as shown in Fig. 3(a), the phase difference detection unit 4 comprises: a front side phase difference detector 4F having the same structure as the phase difference detection unit 4 shown in Fig. 2(b); and a rear side phase difference detector 4R which receives the phase difference detection signals E1, E2 output from the phase difference detector 4F and outputs the phase difference detection signals E12, E22 which have been given a further phase difference $\alpha$.

Here, the rear side phase difference detector 4R includes multipliers 4g, 4h, 4i, an adder 4j and a subtractor 4k. After the multiplier 4g has multiplied together the phase difference detection signals E1 and E2 output from the phase difference detector 4F, the adder 4j adds the multiplication result, thereby generating a phase difference detection signal E12 having a phase difference $2\alpha$.

Further, the subtractor 4k operates to calculate a difference between a computation result obtained by squaring the phase difference detection signal E2 using the multiplier 4i and a computation result obtained by squaring the phase difference detection signal E1 using the multiplier 4h, thereby generating a phase difference detection signal E22 having a phase difference $2\alpha$.

Next, as shown in Fig. 3(b), the phase difference correction unit 5 has the same structure as the phase difference correction unit 5 shown in Fig. 2(c). Nevertheless, the phase difference correction unit 5 of the present embodiment receives the phase difference detection signals E12 and E22 each having a phase difference $2\alpha$, a signal component S2 and a phase-shifted signal P2 each having a phase difference $2\alpha$.

By virtue of the above constitution, the subtractor 5e outputs an output signal Sout represented by a cosine wave Kcos($\omega$t) having phase difference $2\alpha$ corrected, as shown in the following equation (9-a), while the adder 5f outputs an output signal Sout represented by a sine wave Ksin($\omega$t) having its phase difference $2\alpha$ corrected, as shown in the following equation (9-b).

Equation 9

$$B\cos(2\alpha)\cdot A\cos(\omega t - 2\alpha) - B\sin(2\alpha)\cdot A\sin(\omega t - 2\alpha)$$
$$= K\cos(\omega t) = Sout \qquad\qquad ---(9-a)$$

$$B\cos(2\alpha)\cdot A\cos(\omega t - 2\alpha) + B\cos(2\alpha)\cdot A\sin(\omega t - 2\alpha)$$
$$= K\sin(\omega t) = Sout \qquad\qquad ---(9-b)$$

As described above, according to the phase correction circuit of the present embodiment, the phase difference correction unit 5 operates in accordance with the phase difference detection signals E12 and E22 which are orthogonal functions taking a phase difference $2\alpha$ as a parameter, so as to shift the phases of the signal component S2 and the phase-shifted signal P2 each having a phase difference $2\alpha$, thereby making it possible to produce an output signal Sout having phase deviation corrected.

Moreover, since no feedback loop exists in a process which lasts until it extracts a desired signal component from an input signal Sin and outputs an output signal Sout having phase deviation corrected, it is possible to extremely quickly generate an output signal Sout having phase deviation corrected.

Further, the phase correction circuit of the present embodiment can be formed either of an analog circuit which performs an analog signal processing, or a digital circuit which performs a digital signal processing.

When the phase correction circuit is formed of a digital circuit, it is possible to highly accurately correct a phase deviation, generate and thus output an output signal Sout consisting of digital signal, without depending upon a frequency precision of a desired signal and the precision of a sampling clock.

Embodiment 3

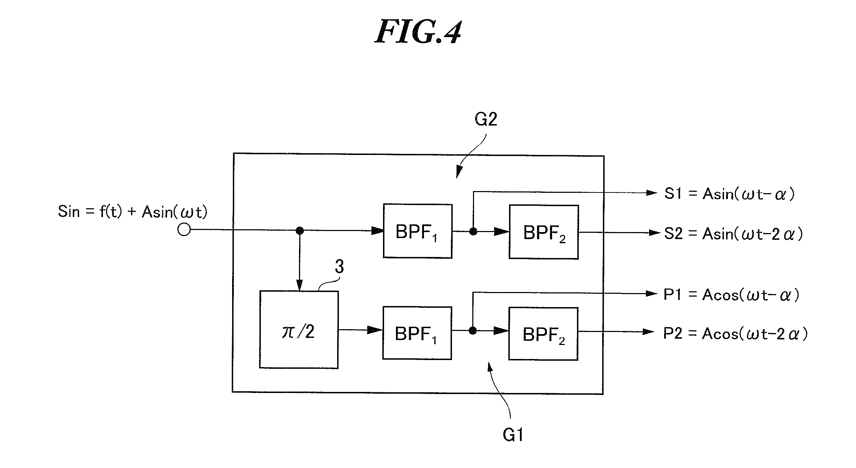

Next, description will be given to explain a further embodiment corresponding to a modification of the embodiment shown in Fig. 2, with reference to Fig. 4.

In the embodiment shown in Fig. 2, as shown in Fig. 2(a), the phase shifting unit 3 operates to shift by $\pi/2$ the phases of the respective signal components S1 and S2 output from the band pass filters BPF1 and BPF2 connected in series, thereby generating the phase-shifted signals P1 and P2. However, in the phase correction circuit of the present embodiment, as shown in Fig. 4, there are provided two filter groups G1 and G2 consisting of the band pass filters BPF1 and BPF2 having various desired characteristics.

One filter group G1 is provided on its input side with a phase shifting unit 3 capable of shifting a phase by $\pi/2$, while the other filter group G2 is not provided with any phase shifting unit. By virtue of the above constitution, the respective signal components S 1 and S2 output from the filter group G2 and the phase-shifted signals P1 and P2 output from the filter group G1 are supplied to the phase difference detection unit 4, thereby generating the phase difference detection signals E1 and E2.

Further, the phase difference detection signals E1 and E2, the signal component S1 and the phase-shifted signal P are supplied to the phase difference correction unit 5, thereby generating and thus outputting an output signal Sout having phase difference $\alpha$ corrected.

Thus, according to the phase correction circuit of the present embodiment, it is possible to at first shift the phase of an input signal Sin by virtue of the phase-shifting unit 3, and then allow the input signal to pass through the band pass filters BFP and BP2.

Moreover, since no feedback loop exists in a process which lasts until it extracts a desired signal component from an input signal Sin and outputs an output signal Sout having phase deviation corrected, it is possible to extremely quickly generate an output signal Sout having phase deviation corrected.

Further, the phase correction circuit of the present embodiment can be formed either of an analog circuit which performs an analog signal processing, or a digital circuit which performs a digital signal processing.

When the phase correction circuit is formed of a digital circuit, it is possible to highly accurately correct a phase deviation, generate and thus output an output signal Sout consisting of digital signal, without depending upon a frequency precision of a desired signal and the precision of a sampling clock.

**Claims**

1.  A phase correction circuit for correcting a phase difference of desired signal component contained in an input signal and then extracting desired signal component, the phase correction circuit comprising:

    filter means having characteristics of several stages for extracting desired signal component contained in the input signal;
    phase shifting means for shifting a predetermined amount of phase of a signal component extracted by each filter means and generating a phase-shifted signal;
    phase difference detection means for performing a computation using an addition theorem of trigonometric functions to process the signal component extracted by each filter means and the phase-shifted signal generated by the phase shifting means, thereby detecting a phase difference of the signal component; and
    phase difference correction means for shifting the phase of the signal component extracted by each filter means and the phase of the phase-shifted signal in accordance with the phase difference detected by the phase difference detection means, thereby generating a signal component having the phase difference corrected.

2. A phase correction circuit for correcting a phase difference of desired signal component contained in an input signal and then extracting desired signal component, the phase correction circuit comprising:

> filter means having characteristics of several stages for extracting desired signal component contained in the input signal;
> phase shifting means for shifting a predetermined amount of phase of the input signal;
> second filter means having characteristics consistent with the first filter means for extracting, from an output signal of the phase shifting means, a phase-shifted signal formed by shifting the predetermined amount of phase of a desired signal component contained in the input signal;
> phase difference detection means for performing a computation using an addition theorem of trigonometric functions to process the signal component extracted from the first filter means and the phase-shifted signal extracted from the second filter means, thereby detecting a phase difference of the signal component; and
> phase difference correction means for shifting the phase of the signal component extracted from the first filter means and the phase-shifted signal extracted from the second filter means in accordance with the phase difference detected by the phase difference detection means, thereby generating a signal component having the phase difference corrected.

3. The phase correction circuit according to claim 1 or 2, wherein the shifted amount of phase is $\pi/2$ or $-\pi/2$.

4. The phase correction circuit according to any one of claims 1 to 3,
   wherein the phase difference detection means generates signal of orthogonal function taking detected phase difference as parameter;
   wherein the phase difference correction means shifts the phases of the signal component and the phase-shifted signal in accordance with the signal of the orthogonal function, thereby generating a signal component having the phase difference corrected.

5. A phase correction method for correcting a phase difference of desired signal component contained in an input signal and then extracting desired signal component, the phase correction method comprising:

> an extraction step for extracting desired signal component contained in the input signal by virtue of filter means having characteristics of several stages;
> a phase shifting step for shifting a predetermined amount of phase of signal component extracted in the extraction step and generating phase-shifted signal;
> a phase difference detection step for performing a computation using an addition theorem of trigonometric functions to process signal component extracted in the extraction step and phase-shifted signal generated in the phase shifting step, thereby detecting a phase difference of signal component; and
> phase difference correction step for shifting the phase of signal component and the phase of phase-shifted signal in accordance with the phase difference detected in the phase difference detection step, thereby generating a signal component having the phase difference corrected.

6. A phase correction method for correcting a phase difference of desired signal component contained in an input signal and then extracting desired signal component, the phase correction method comprising:

> a signal component extraction step for extracting desired signal component contained in the input signal by virtue of the first filter means having characteristics of several stages;
> a phase shifting step for shifting a predetermined amount of phase of the input signal;
> a phase signal extraction step for extracting, from a signal phase-shifted in the phase shifting step, a phase-shifted signal formed by shifting a predetermined amount of phase of desired signal component contained in the input signal, by virtue of second filter means having characteristics consistent with the first filter means;
> a phase difference detection step for performing a computation using an addition theorem of trigonometric functions to process signal component extracted in the signal component extraction step and phase-shifted signal extracted in the phase signal extraction step, thereby detecting a phase difference of the signal component; and
> a phase difference correction step for shifting the phase of signal component and the phase of phase-shifted signal in accordance with the phase difference detected in the phase difference detection step, thereby generating a signal component having the phase difference corrected.

# FIG.1

EP 1 895 662 A1

*FIG.2 (a)*

*FIG.2 (b)*

*FIG.2 (c)*

# FIG.3 (a)

$E2 = B\cos(\alpha)$

$S1 = A\sin(\omega t - \alpha)$

$S2 = A\sin(\omega t - 2\alpha)$

$P2 = A\cos(\omega t - 2\alpha)$

$P1 = A\cos(\omega t - \alpha)$

$E12 = B\sin(2\alpha)$

$E22 = B\cos(2\alpha)$

$E1 = B\sin(\alpha)$

# FIG.3 (b)

$S2 = A\sin(\omega t - 2\alpha)$

$E12 = B\sin(2\alpha)$

$E22 = B\cos(2\alpha)$

$P2 = A\cos(\omega t - 2\alpha)$

$K\cos(\omega t)$

$K\sin(\omega t)$

Sout

EP 1 895 662 A1

## FIG.4

Sin = f(t) + Asin($\omega$t)

G2

3

$\pi$/2

BPF$_1$

BPF$_1$

BPF$_2$

BPF$_2$

S1 = Asin($\omega$t − $\alpha$)

S2 = Asin($\omega$t − 2$\alpha$)

P1 = Acos($\omega$t − $\alpha$)

P2 = Acos($\omega$t − 2$\alpha$)

G1

EP 1 895 662 A1

## INTERNATIONAL SEARCH REPORT

| International application No. |
| --- |
| PCT/JP2006/310338 |

**A. CLASSIFICATION OF SUBJECT MATTER**
*H03L7/00*(2006.01)i

According to International Patent Classification (IPC) or to both national classification and IPC

**B. FIELDS SEARCHED**

Minimum documentation searched (classification system followed by classification symbols)
H03L7/00-7/23, H04H5/00, G11B20/10

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 10-126359 A (Matsushita Electric Industrial Co., Ltd.), 15 May, 1998 (15.05.98), (Family: none) | 1-6 |
| A | JP 08-265382 A (Toshiba Corp.), 11 October, 1996 (11.10.96), Par. Nos. [0020] to [0032] (Family: none) | 1-6 |

☐ Further documents are listed in the continuation of Box C.   ☐ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 17 August, 2006 (17.08.06) | 29 August, 2006 (29.08.06) |

| Name and mailing address of the ISA/ | Authorized officer |
| --- | --- |
| Japanese Patent Office | |
| Facsimile No. | Telephone No. |

Form PCT/ISA/210 (second sheet) (April 2005)